# EUROPÄISCHE PATENTSCHRIFT

(11) **EP 0 561 169 B1**
(45) Veröffentlichungstag und Bekanntmachung des Hinweises auf die Patenterteilung: **05.11.1997**
(21) Anmeldenummer: 93102582.9
(22) Anmeldetag: 19.02.1993
(51) Int. Cl.: G01R 13/22, G01R 19/00

(54) **Vorrichtung zum Verarbeiten von Signalen**
Signal processing device
Dispositif de traitement de signaux

(30) Priorität: 19.03.1992 DE 4208827
(43) Veröffentlichungstag der Anmeldung: 22.09.1993
(73) Patentinhaber: ROBERT BOSCH GMBH, 70442 Stuttgart (DE)
(72) Erfinder: Gern, Christian, Dipl.-Ing., W-7314 Wernau (DE)

(56) Entgegenhaltungen:
- EP-A- 0 044 436
- EP-A- 0 140 396
- EP-A- 0 507 470
- DE-C- 3 700 368
- GB-A- 2 014 812
- US-A- 4 713 771
- US-A- 5 115 404
- HP JOURNAL, Bd.43, Nr.1, Februar 1992, US Seiten 11 - 20 M.S.HOLCOMB ET AL. 'A High-Throughput Acquisition Architecture for a 100-MHz Digitizing Oscilloscope'
- MESURES, Bd.57, Nr.644, April 1992, PARIS FR Seiten 57 - 59 G.EUDE 'Oscillos: Une architecture pour mieux analyser'
- ELEKTRONIK., Bd.40, Nr.14, Juli 1991, MUNCHEN DE Seiten 38 - 42 W.HASCHER 'Digital-Speicheroszilloskope: Handbuch (fast) überflüssig'
- TEKTRONIX 96453-EMS-598-10.91 ps, "ScopeStation, Digital-Oszilloskope, Serie TDS 400", Oktober 1991

## Beschreibung

Die Erfindung geht aus von einer Vorrichtung zum Verarbeiten von Signalen in einer Signalerfassungsanordnung nach der Gattung des unabhängigen Anspruchs 1.

Aus der GB-A 20 14 812 ist eine gattungsgemäße Signalerfassungsanordnung bekannt, bei der ein Eingangssignal mit einer vorgegebenen Abtastrate abgetastet und anschließend einem Analog/Digital-Wandler zugeführt wird. Neben der Abtastrate, mit der das Signal abgetastet wird, ist ein längeres Zeitintervall zur Signalauswertung vorgesehen. Weitergeleitet und zur Darstellung gebracht wird entweder der in dem längeren Zeitintervall aufgetretene Mittelwert des Signals oder ein Extremwert des Signals, sofern ein solcher festgestellt wurde.

Aus Unterlagen der Firma Tektronix, 96453-EMS-598-10.91 ps, "ScopeStation, Digital-Oszilloskope, Serie TDS 400", Oktober 1991, sind als Beispiel für Signalerfassungsanordnungen Digital-Speicheroszilloskope genannt, die in einer vorgebbaren Betriebsart (High-Resolution-Modus) den Mittelwert des innerhalb eines Intervall liegenden erfaßten Signales bilden, der anschließend an der dem Intervall zugeordneten Stelle auf der Anzeigevorrichtung ausgegeben wird. In dieser Betriebsart werden von einem Analog/Digital-Wandler mehrere Werte des im Intervall liegenden Signals abgetastet, damit ein Mittelwert gebildet werden kann. Die Mittelwertbildung reduziert das hochfrequente Rauschen. In einer anderen Betriebsart (Peak Detect) arbeitet der Analog/Digital-Wandler stets mit der maximal möglichen Abtastrate. In dieser Betriebsart werden unabhängig von der vorgegebenen Ablenkgeschwindigkeit Extremwerte des zu verarbeitenden Signals erfaßt und anstelle eines in dem vorgegebenen Intervall liegenden Abtastwertes auf der Anzeigevorrichtung dargestellt. Die Extremwerterfassung weist den Nachteil eines erhöhten Systemrauschens auf, weil jede Rauschspitze erfaßt wird und das Rauschen mit höherer Bandbreite zunimmt. Die Bandbreite ist in dieser Betriebsart auf den höchsten Wert der Signalerfassungsanordnung festgelegt, die durch die maximal mögliche Abtastrate des Analog/Digital-Wandlers gegeben ist.

Der Erfindung liegt die Aufgabe zugrunde, eine Vorrichtung zum Verarbeiten von Signalen in einer Signalerfassungsanordnung anzugeben, die eine Extremwerterfassung bei minimalem Rauschen ermöglicht.

Die Aufgabe wird durch die im Hauptanspruch angegebenen Merkmale gelöst.

### Vorteile der Erfindung

Erfindungsgemäß ist vorgesehen, daß in der Signalerfassungsanordnung nur dann ein oder zwei Extremwerte des zu verarbeitenden Signals weitergeleitet werden, wenn die Differenz zwischen dem erfaßten Maximum und dem erfaßten Minimum innerhalb eines Intervalls eine vorgegebene Schwelle übersteigt. Solange die Schwelle nicht überschritten ist, wird ein Mittelwert des im Intervall liegenden erfaßten Signals weitergeleitet. Der wesentliche Vorteil liegt darin, daß das Rauschen des weitergeleiteten Signals auf ein unvermeidbares Maß reduziert ist, ohne daß auf die zusätzliche Funktion der Extremwerterfassung verzichtet werden muß.

Vorteilhafte Weiterbildungen und Verbesserungen der erfindungsgemäßen Vorrichtung ergeben sich aus Unteransprüchen.

Die vorzugebende Schwelle ist vorzugsweise in Abhängigkeit vom theoretisch ermittelbaren oder meßbaren Rauschen der Signalerfassungsanordnung gewählt. Im Extremfall kann die Schwelle vor jeder Verarbeitung des Signals neu festgelegt werden.

Besonders vorteilhaft ist der Einsatz eines Analog/Digital-Wandlers, der eine digitale Signalverarbeitung des erfaßten Signals ermöglicht. Die Abtastrate des Analog/Digital-Wandlers ist derart festzulegen, daß mehr Werte des Signals digitalisiert werden als später weitergeleitet werden. Mit dieser Maßnahme ist eine Mittelwertbildung möglich.

Eine vorteilhafte Ausgestaltung sieht vor, daß die Abtastrate des Analog/Digital-Wandlers auf den maximal möglichen Wert des Wandlers festgelegt ist. Damit ist eine vollständige digitale Signalverarbeitung möglich.

In einer anderen vorteilhaften Ausgestaltung ist vorgesehen, daß die Mittel zum Erfassen des Maximums und die des Minimums des zu verarbeitenden Signals sowie die Mittel zum Bestimmen des Mittelwertes analog arbeiten und daß deren Ausgangssignale in zyklischer Folge dem Analog/Digital-Wandler zugeführt sind. Diese Ausgestaltung weist den Vorteil auf, daß der Wandler nur eine vergleichsweise niedrige maximale Abtastrate aufweisen muß, ohne daß auf den Vorteil der Extremwerterfassung verzichtet werden muß. Bei gleicher Auflösung sind langsamere Analog/Digital-Wandler erheblich preisgünstiger als schnellere Wandler.

In einer Weiterbildung ist vorgesehen, daß die Mittel zum Erfassen des Mittelwertes als Tiefpaß-Filter realisiert sind. Vorzugsweise ist vorgesehen, die Grenzfrequenz des Tiefpaß-Filters in Abhängigkeit von der Abtastrate des Analog/Digital-Wandlers festzulegen. Insbesondere in analoger Schaltungstechnik ist das Tiefpaß-Filter preisgünstig realisierbar, wobei die Grenzfrequenz auf einen Wert festlegbar ist, der derzeit von Digitalfiltern nur mit hohem Aufwand realisierbar ist.

Die erfindungsgemäße Vorrichtung ist insbesondere geeignet zur Verwendung in einem digitalen Speicheroszilloskop.

Weitere vorteilhafte Weiterbildungen und Verbesserungen ergeben sich aus weiteren Unteransprüchen in Verbindung mit der folgenden Beschreibung.

### Zeichnung

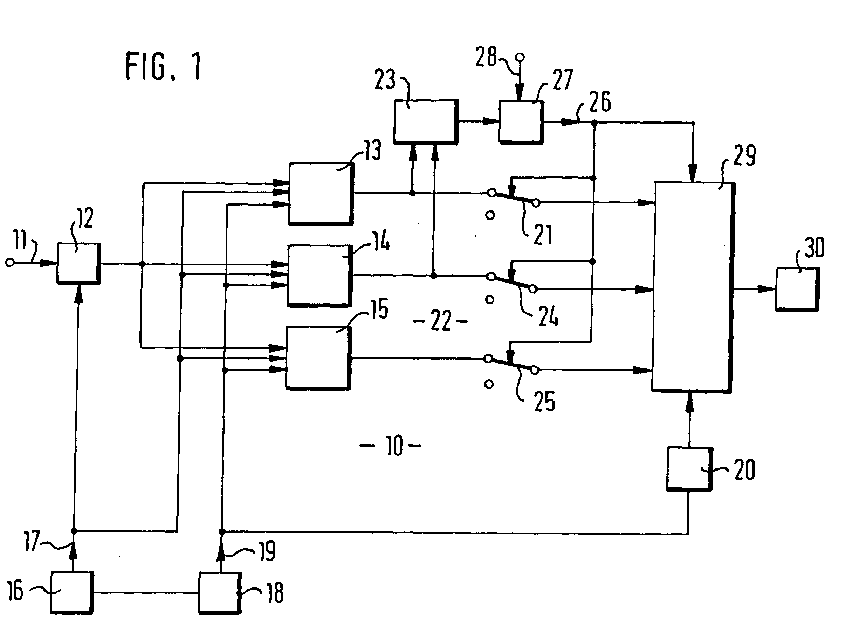

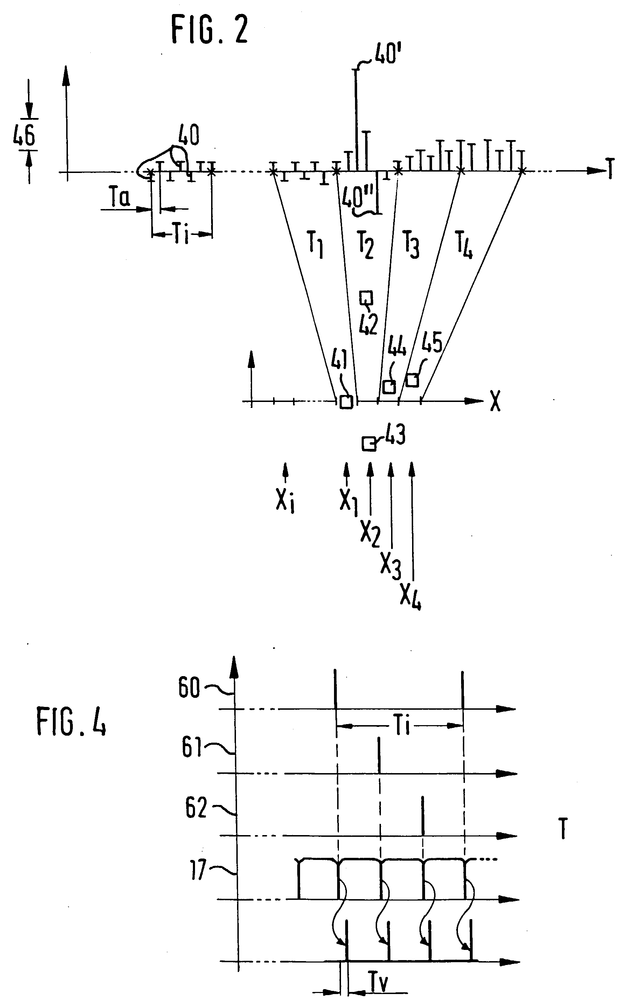

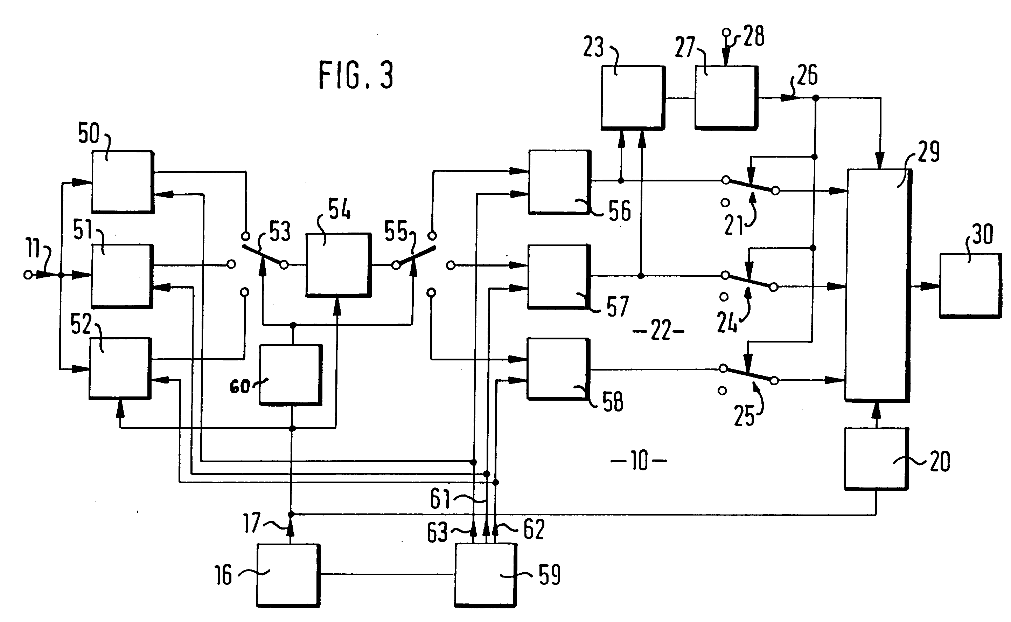

Ein Blockschaltbild einer erfindungsgemäßen Vorrichtung zum Verarbeiten von Signalen ist in Figur 1 gezeigt. Figur 2 zeigt Signalverläufe in Abhängigkeit von der Zeit und in Abhängigkeit vom Ort. Figur 3 zeigt ein weiteres Blockschaltbild einer erfindungsgemäßen Vorrichtung zum Verarbeiten von Signalen und Figur 4 zeigt Signalverläufe in Abhängigkeit von der Zeit, die in der Vorrichtung gemäß Figur 3 auftreten.

Figur 1 zeigt eine Anordnung 10 zum Erfassen eines Signals 11. Das Signal 11 ist einem Analog/Digital-Wandler 12 zugeführt, der ein Ausgangssignal an Mittel 13 zum Erfassen eines Maximums des Signals 11, an Mittel 14 zum Erfassen eines Minimums des Signals 11 und an einen Mittelwertbildner 15 zum Ermitteln eines Mittelwertes des Signals 11 abgibt. Ein von einem ersten Taktgenerator 16 abgegebenes erstes Taktsignal 17 ist dem Analog/Digital-Wandler, den Mitteln 13, 14 sowie dem Mittelwertbildner 15 zugeführt. Ein zweiter Taktgenerator 18 gibt ein zweites Taktsignal 19 an die Mittel 13, 14, an den Mittelwertbildner 15 sowie an eine Signalverzögerung 20 ab. Die Taktgeneratoren 16, 18 sind miteinander verbunden.

Das ermittelte Maximum gelangt sowohl an einen ersten Schalter 21 von Auswahlmitteln 22 als auch an Differenzbildungsmittel 23. Das ermittelte Minimum gelangt sowohl an einen zweiten Schalter 24 der Auswahlmittel 22 als auch ebenfalls an die Differenzbildungsmittel 23. Der Mittelwertbildner 15 gibt den Mittelwert an einen dritten Schalter 25 der Auswahlmittel 22 ab.

Die Schalter 21, 24, 25 der Auswahlmittel 22 werden von einem Auswahlsignal 26 gesteuert, das von Vergleichsmitteln 27 abgegeben wird. Die Vergleichsmittel 27 erhalten ein Ergebnis des Differenzbildungsmittels 23 und ein Schwellenvorgabesignal 28 zugeleitet.

Das Auswahlsignal 26 ist weiterhin einem Speicher 29 zugeführt, der zum Speichern der von den Auswahlmitteln 22 weitergeleiteten Signale vorgesehen ist. Der Speicher 29 wird über die Signalverzögerung 20 vom zweiten Taktgenerator 18 angesteuert. Der Speicher 29 gibt ein Ausgangssignal an eine Anzeigevorrichtung 30 ab.

Im oberen Teil von Figur 2 ist das Ausgangssignal des Analog/Digital-Wandlers 12 in Abhängigkeit von der Zeit T gezeigt. Der zeitliche Abstand zwischen zwei Abtastwerten 40 beträgt Tₐ. Die Abtastrate des Analog/Digital-Wandlers 12 ist durch die Abtastzeit Tₐ gegeben, die vom ersten Taktsignal 17 des ersten Taktgenerators 16 abgeleitet ist. Innerhalb eines vorgegebenen Intervalls Tᵢ liegt eine vorgegebene Anzahl von Abtastwerten 40. Eingetragen ist die Schwelle 46, die einen vorgegebenen Betrag aufweist, welcher einen Bezug zu den Beträgen der Abtastwerte 40 hat.

Jedem Intervall Tᵢ ist eine bestimmte Position X im Speicher 29 zugeordnet, die im unteren Teil von Figur 2 gezeigt ist. Das Intervall T₁ ist der Position X₁, das Intervall T₂ der Position X₂, das Intervall T₃ der Position X₃ und das Intervall T₄ der Position X₄ zugeordnet. An den Positionen Xᵢ sind Werte 41, 42, 43, 44, 45 der von den Auswahlmitteln 22 weitergeleiteten Signalen gezeigt. Die Werte 41, 44, 45 an den Positionen X₁, X₃, X₄ entsprechen jeweils Mittelwerten der in den jeweils zugeordneten Intervallen T₁, T₃, T₄ liegenden Abtastwerten 40. Die an der Position X₂ eingetragenen Werte 42, 43 sind Extremwerte, die den im Intervall T₂ abgetasteten Extremwerten 40', 40'' entsprechen.

Die erfindungsgemäße Vorrichtung gemäß Figur 1 wird anhand von Figur 2 näher erläutert:

Die Signalerfassungsanordnung 10 ist zum Verarbeiten des Signals 11 vorgesehen. Die Signalerfassungsanordnung 10 verarbeitet einerseits den vom Mittelwertbildner 15 ermittelen Mittelwert des Signals 11, ohne andererseits auf die Verarbeitung von Extremwerten des Signals 11 zu verzichten. Zur Ermittlung der Extremwerte sind die Mittel 13 zum Erfassen des Maximums des Signals 11 und die Mittel 14 zum Erfassen des Minimums des Signals 11 vorgesehen. Sowohl die Ermittlung des Mittelwertes als auch die Erfassung von Extremwerten des Signals 11 ist jeweils auf ein vorgegebenes Intervall Tᵢ bezogen, welches durch das vom zweiten Taktgenerator 18 abgegebene zweite Taktsignal 19 festgelegt ist. Die Auswahlmittel 22 haben die Aufgabe, entweder den vom Mittelwertbildner 15 ermittelten Mittelwert des Signals 11 oder wenigstens einen, von den Mitteln 13, 14 erfaßten Extremwert weiterzuleiten. Die Auswahlmittel 22 enthalten beispielsweise elektronisch steuerbare Schalter 21, 24, 25, die mit dem Auswahlsignal 26 gesteuert werden. Eine Umschaltung der Weiterleitung vom Mittelwert zu wenigstens einem Extremwert wird dann vorgenommen, wenn die von den Differenzbildungsmitteln 23 ermittelte Differenz zwischen dem Maximum und dem Minimum des Signals 11 die vorgegebene Schwelle 46 überschreitet. Der Vergleich wird in den Vergleichsmitteln 27 vorgenommen, die das Auswahlsignal 26 abgeben. Die Schwelle 46 ist entweder als Festwert vorgegeben oder über das Schwellenvorgabesignal 28 einstellbar.

Die Schwelle 46 wird vorzugsweise derart festgelegt, daß sie das im jeweiligen Betriebszustand der Signalerfassungsanordnung 10 auftretende Rauschen übersteigt. Das Rauschen nimmt im allgemeinen bei höherer Bandbreite des zu verarbeitenden Signals 11 zu. Die Bandbreite der Anordnung 10 ist auf die Signalfrequenz der zur Verarbeitung noch zugelassenen Extremwerte 40', 40'' des Signals 11 auszulegen. Die Forderung nach Erfassung von Extremwerten 40', 40'' im Signal 11 führt daher im allgemeinen zu einem höheren Rauschen als es bei der Weiterleitung lediglich eines in einem Intervall Tᵢ auftreten würde. Die im Mittelwertbildner 15 vorgesehene Mittelwertbildung reduziert das Rauschen des weitergeleiteten Signals auf das unvermeidliche Maß, das bei der bandbreitenbegrenzten Verarbeitung des Signals 11 ohne Extremwerterkennung systembedingt gegeben ist. Die Schwelle 46 kann bei gegebener maximaler Bandbreite theoretisch ermittelt werden. Vorzugsweise wird die Schwelle 46 experimentell ermittelt, wobei die Anordnung 10 ohne Signal 11 betrieben wird. Die Schwelle 46 kann im Extremfall vor jeder Verarbeitung des Signals 11 neu ermittelt werden. Die Weiterleitung entweder des Mittelwertes oder wenigstens eines Extremwertes des Signals 11 wird nach Ablauf jedes Intervalls Tᵢ erneut festgelegt. Die Mittel 13, 14 zum Erfassen der Extremwerte und der Mittelwertbildner 15 erhalten durch das zweite Taktsignal 19 die Information, wann das Intervall Tᵢ beendet ist und werden daraufhin in einen definierten Anfangszustand zurückgesetzt.

In einer vorteilhaften Weiterbildung ist der Analog/Digital-Wandler 12 vorgesehen, der das Signal 11 in die in Figur 2 gezeigten digitalen Abtastwerte 40 umwandelt. Die Anordnung des Wandlers 12 unmittelbar am Eingang der Anordnung 12 weist den Vorteil auf, daß die nachfolgende Signalverarbeitung vollständig in digitaler Schaltungstechnik oder in Form von Software in einem Mikrocomputer vorgenommen werden kann. Die Abtastrate, die vom ersten Taktgenerator 16 festgelegt ist, gibt die Anzahl der Abtastwerte 40 vor, die innerhalb eines Intervalls Tᵢ auftreten. Die Abtastrate, die der Zeit Tₐ entspricht, ist derart festzulegen, daß die Extremwerte 40', 40'' des Signals 11 vom Wandler 12 erfaßt werden können. Das erste Taktsignal 17, das die Abtastrate vorgibt, ist gegebenenfalls den Mitteln 13, 14 sowie dem Mittelwertbildner 15 zugeführt, die mit diesem Signal die Information erhalten, wann ein neuer Wert vorliegt. Diese Information kann auch unmittelbar vom Wandler 12 abgegeben werden.

Die von den Auswahlmitteln 22 weitergeleiteten Signale werden vorzugsweise im Speicher 29 an vorgegebenen Speicherplätzen hinterlegt. Zur Steuerung des Speichers 29 sind die Signalverzögerung 20 und das Auswahlsignal 26 vorgesehen. Das von der Signalverzögerung 20 abgegebene Signal legt die Positionen Xᵢ im Speicher 29 fest. Die Signalverzögerung 20 stellt sicher, daß die neue Position Xᵢ₊₁ für die Ablage der im Intervall Tᵢ ermittelten Werte erst dann im Speicher 29 festgelegt wird, wenn die Werte vorliegen und von den Auswahlmitteln 22 weitergeleitet werden können. Mittels des Auswahlsignals 26 ist die Umschaltung zwischen einem oder zwei Speicherplätzen für die Werte eines Intervalls Tᵢ möglich. Ein Speicherplatz wird benötigt, wenn der Mittelwert abgelegt wird. Zwei Speicherplätze sind erforderlich, wenn die beiden Extremwerte gleichzeitig abgelegt werden sollen. Sofern lediglich ein Extremwert weiterverarbeitet werden soll, kann die Ansteuerung des Speichers mittels des Auswahlsignals 26 entfallen. Der Speicher 29 ist für die Verarbeitung sowohl von Analogsignalen in analoger Schaltungstechnik, beispielsweise als MOS-Eimerkettenspeicher, als auch für die Verarbeitung von Digitalsignalen als Digitalwertspeicher realisierbar.

Die erfindungsgemäße Vorrichtung ist besonders geeignet zur Verwendung in einem Digital-Speicheroszilloskop. bei dem die im Speicher 29 hinterlegten Werte auf der Anzeigevorrichtung 30 angezeigt werden. Die Anzeigevorrichtung 30 weist in horizontaler (X-)Richtung eine Ausdehung auf, die es ermöglicht, zahlreiche nacheinander liegende Intervalle Tᵢ darzustellen. Für eine optisch gute Darstellung werden wenigstens 10 Intervalle Tᵢ pro 1 cm benötigt. Ausgegeben werden die den Positionen Xᵢ zugeordneten Werte 41, 42, 43, 44, 45, die beispielsweise als einzelne Punkte oder als Vektoren dargestellt werden. Die Vektoren verbinden die einzelnen gedachten Punkte miteinander. Die Extremwerte 42, 43 können bei der Vektordarstellung mit einem geringen örtlichen Versatz dargestellt werden, so daß sich nicht zwangsläufig eine einzelne senkrechte Linie ergibt.

Figur 3 zeigt ein Blockschaltbild eines anderen Ausführungsbeispiels der Signalerfassungsanordnung 10. Diejenigen in Figur 3 gezeigten Teile, die mit den in Figur 1 gezeigten Teilen übereinstimmen, tragen jeweils dieselben Bezugszeichen. Das Signal 11 gelangt zunächst zu Mitteln 50, 51, die das Maximum und das Minimum des Signals 11 erfassen. Das Signal 11 gelangt weiterhin an einen Mittelwertbildner 52, der den Mittelwert des Signals 11 ermittelt. Die Mittel 50, 51 sowie der Mittelwertbildner 52 sind in analoger Schaltungstechnik realisiert. Ausgänge der Mittel 50, 51 und des Mittelwertbildners 52 sind mit einem ersten Umschalter 53 verbunden, der eines der Signale an einen Analog/Digital-Wandler 54 weiterleitet. Der Wandlerausgang ist mit einem zweiten Umschalter 55 verbunden, der das Ausgangssignal des Analog/Digital-Wandlers 54 entweder an einen Maximalwertspeicher 56, an einen Minimalwertspeicher 57 oder an einen Mittelwertspeicher 58 weiterleitet. Zur Ablaufsteuerung sind der erste Taktgenerator 16 sowie ein weiterer Taktgenerator 59 vorgesehen. Der Taktgenerator 59 gibt die Signale 60, 61, 62 aus, die den Mitteln 50, 51, dem Mittelwertbildner 52 sowie den Speichern 56, 57, 58 zugeführt sind. Das erste Taktsignal 17 des ersten Taktgenerators 16 gelangt an die Verzögerung 20, an den Mittelwertbildner 52, an den Analog/Digital-Wandler 54 und an eine Schaltersteuerung 60. Die Schaltersteuerung 60 gibt Schaltsignale an den ersten und zweiten Umschalter 53, 55 ab.

In Figur 4 sind die Steuersignale 60, 61, 62, das erste Taktsignal 17 sowie das von der Verzögerung 20 abgegebene Signal in Abhängigkeit von der Zeit T gezeigt. Eingetragen in Figur 4 ist das Intervall Tᵢ sowie die Verzögerungszeit Tᵥ zwischen dem ersten Taktsignal 17 und dem von der Verzögerung 20 abgegebenen Signal.

Die Funktion der in Figur 3 gezeigten Anordnung 10 wird anhand der in Figur 4 gezeigten Signalverläufe näher erläutert:

Das zu verarbeitende Signal 11 wird zunächst in den Mitteln 50, 51 und im Mittelwertbildner 52, die jeweils in analoger Schaltungstechnik realisiert sind, vorverarbeitet. Erst danach werden die vorverarbeiteten Signale in zyklischer Folge mittels des ersten Umschalters 53 dem Analog/Digital-Wandler 54 zugeleitet. Der Vorteil dieser Maßnahme liegt darin, daß ein erheblich langsamerer Analog/Digital-Wandler 54 als im Ausführungsbeispiel gemäß Figur 1 zum Einsatz gelangen kann. Dieser Vorteil wird dadurch erreicht, daß zumindest die Extremwerte von den Mitteln 50, 51 erfaßt werden, die innerhalb eines Intervalls Tᵢ aufgetreten sind. Die Abtastrate des Analog/Digital-Wandlers 54 muß daher lediglich auf das vorgegebene Intervall Tᵢ abgestimmt werden. Bedingt durch die sukzessive Arbeitsweise, kann die Abtastrate jedoch nicht niedriger gewählt werden als die Zeit, die einem Drittel des Intervalls Tᵢ entspricht, damit die drei vorverarbeiteten Werte innerhalb des Intervalls Tᵢ digitalisiert werden können. Die sukzessive Arbeitsweise macht die beiden Umschalter 53, 55 sowie die Schaltersteuerung 60 erforderlich, die dafür sorgen, daß der gerade digitalisierte Wert in den entsprechenden Speicher 56, 57, 58 abgelegt wird. Die Schaltersteuerung 60 erhält das erste Taktsignal 17 zugeleitet, dessen Periodendauer höchstens einem Drittel der des Intervalls Tᵢ entspricht. Eine schnellere Abtastrate kann zwar vorgesehen sein, ist im vorliegenden Fall jedoch nicht erforderlich. Nach jeder Periode des ersten Taktsignals 17 werden die Umschalter 53, 55 in eine andere Position bewegt. Die vom weiteren Taktgenerator 59 abgegebenen Steuersignale 60, 61, 62 weisen einen festen zeitlichen Bezug zum ersten Taktsignal 17 auf. Der weitere Taktgenerator 59 ist beispielsweise realisierbar als Zähler, der den maximalen Zählerstand 3 annehmen kann, dessen Takteingang vom ersten Taktgenerator 17 angesteuert wird. Gegebenenfalls kann zur Ansteuerung das erste Taktsignal 17 verwendet werden. Die Steuersignale 60, 61, 62 setzen nach Ablauf eines Intervalls Tᵢ zeitlich versetzt um jeweils 1/3 des Intervalls Tᵢ die Mittel 50, 51 sowie den Mittelwertbildner 52 in einen definierten Grundzustand zurück. Gleichzeitig können die Steuersignale 60, 61, 62 dafür vorgesehen sein, den mittels des zweiten Umschalters 55 jeweils weitergeleiteten Wert in die Speicher 56, 57, 58 zu übernehmen. Diese Speichersteuersignale können auch vom Analog/Digital-Wandler 54 abgegeben werden, sofern dieser wenigstens ein Ausgangssignal aufweist, das anzeigt, das der Wandlungsvorgang beendet ist und das Ergebnis vorliegt. Die weitere Signalverarbeitung der in der Figur 3 gezeigten Anordnung 10 entspricht der der in Figur 1 gezeigten Anordnung 10.

In einem weiteren Ausführungsbeispiel der Anordnung 10 kann gegenüber der Anordnung nach Figur 3 die Ermittlung der Differenz zwischen Maximum und Minimum unmittelbar mit den von Mitteln 50, 51 abgegebenen Signalen vorgesehen sein. Die Speicher 56, 57, 58 können entfallen.

In einer vorteilhaften Ausgestaltung wird dem Mittelwertbildner 52 das erste Taktsignal 17 zugeleitet. Der Mittelwertbildner 52 ist beispielsweise als Tiefpaß-Schaltung realisiert, deren Grenzfrequenz mittels des ersten Taktsignals 17 verändert wird. Mit dieser Maßnahme ist die Zeit für die Mittelwertbildung an das vorgegebene Intervall Tᵢ anpaßbar.

Der Mittelwertbildner 15 gemäß Figur 1 und der Mittelwertbildner 52 gemäß Figur 3 bilden vorzugsweise den arithmetischen Mittelwert des Signals 11.

## Patentansprüche

1. Vorrichtung zum Verarbeiten von Signalen in einer Signalerfassungsanordnung (10), mit Mitteln (13, 14, 50, 51) zum Erfassen des innerhalb eines Zeitinvervalls (Tᵢ) liegenden Signalmaximums (40', 42) und Signalminimums (40'', 43) als Extremwerte und einem Mittelwertbildner (15, 52) zum Ermitteln eines Mittelwertes des innerhalb des Zeitintervalls (Tᵢ) liegenden Signals (11), dadurch gekennzeichnet, daß Differenzbildungsmittel (23) zum Bilden der Differenz zwischen dem Signalmaximum (40', 42) und dem Signalminimum (40'', 43), Vergleichsmittel (27) zum Vergleichen der Differenz mit einer Schwelle (46) und Auswahlmittel (22) zum Auswählen zwischen dem Mittelwert und wenigstens einem der Extremwerte (40', 40") vorgesehen sind, die derart ausgestaltet sind, daß die Auswahlmittel (22) den oder die Extremwerte (40', 40") weiterleiten, wenn die Schwelle (46) überschritten ist und den Mittelwert weiterleiten, wenn die Schwelle (46) nicht überschritten ist.

2. Vorrichtung nach Anspruch 1, dadurch gekennzeichnet, daß ein Analog/Digital-Wandler (12, 54) vorgesehen ist, der das Signal (11) mit einer vorgegebenen Abtastrate digitalisiert, die mehr Werte (40) des Signals (11) liefert als weitergeleitet werden.

3. Vorrichtung nach Anspruch 2, dadurch gekennzeichnet, daß die Abtastrate des Analog/Digital-Wandlers (12) auf den maximal möglichen Wert des Wandlers (12) festgelegt ist.

4. Vorrichtung nach einem der Ansprüche 1 bis 3, dadurch gekennzeichnet, daß ein Speicher (29) zum Ablegen der weitergeleiteten Extremwerte (40' 40", 42, 43) und des Mittelwerts sowie eine Anzeigevorrichtung (30) zur Wiedergabe der gespeicherten Werte (42, 43) vorgesehen sind.

5. Vorrichtung nach einem der Ansprüche 1, 2 oder 4, dadurch gekennzeichnet, daß die Mittel (50, 51) zum Erfassen des Maximums und die des Minimums sowie der Mittelwertbildner (52) analog arbeiten, daß deren Ausgänge in zyklischer Folge dem Analog/Digital-Wandler (54) zugeführt sind, dessen Abtastrate auf einen Wert festgelegt ist, der höchstens einem Drittel des Intervalls (Tᵢ) entspricht.

6. Vorrichtung nach Anspruch 5, dadurch gekennzeichnet, daß der Mittelwertbildner (15, 52) als Tiefpaß realisiert ist.

7. Vorrichtung nach Anspruch 6, dadurch gekennzeichnet, daß die Grenzfrequenz des Tiefpasses in Abhängigkeit von der Abtastrate des Analog/Digital-Wandlers (12, 54) festgelegt ist.

8. Vorrichtung nach einem der vorhergehenden Ansprüche, dadurch gekennzeichnet, daß die Schwelle (46) in Abhängigkeit vom Systemrauschen festgelegt ist, das ohne zu verarbeitendes Signal (10) ermittelt wird.

9. Verwendung der Vorrichtung nach einem der vorhergehenden Ansprüche in einem digitalen Speicheroszilloskop.

## Claims

1. Device for processing signals in a signal acquisition arrangement (10), having means (13, 14, 50, 51) for acquiring the signal maximum (40', 42) and signal minimum (40'', 43), which lie within a time interval (Tᵢ), as extreme values, and having an averaging unit (15, 52) for determining an average value of the signal (11) which lies within the time interval (Tᵢ), characterized in that difference-forming means (23) for forming the difference between the signal maximum (40', 42) and the signal minimum (40", 43), comparison means (27) for comparing the difference with a threshold (46) and selection means (22) for selection between the average value and at least one of the extreme values (40', 40") are provided which are configured in such a way that the selection means (22) forward the extreme value or values (40', 40") if the threshold (46) is exceeded, and forward the average value if the threshold (46) is not exceeded.

2. Device according to Claim 1, characterized in that an analog/digital converter (12, 54) is provided, which digitizes the signal (11) at a predetermined sampling rate which supplies more values (40) of the signal (11) than are forwarded.

3. Device according to Claim 2, characterized in that the sampling rate of the analog/digital converter (12) is fixed at the maximum possible value of the converter (12).

4. Device according to one of Claims 1 to 3, characterized in that a memory (29) for storing the forwarded extreme values (40', 40", 42, 43) and the average value as well as a display device (30) for reproducing the stored values (42, 43) are provided.

5. Device according to one of Claims 1, 2 or 4, characterized in that the means (50, 51) for acquiring the maximum and those for the minimum as well as the averaging unit (52) operate in an analog manner, and in that their outputs are fed in a cyclical sequence to the analog/digital converter (54), whose sampling rate is fixed at a value which corresponds at most to a third of the interval (Tᵢ).

6. Device according to Claim 5, characterized in that the averaging unit (15, 52) is realized as a low-pass filter.

7. Device according to Claim 6, characterized in that the cut-off frequency of the low-pass filter is defined as a function of the sampling rate of the analog/digital converter (12, 54).

8. Device according to one of the preceding claims, characterized in that the threshold (46) is defined as a function of the system noise, which is determined without the signal (10) to be processed.

9. Use of the device according to one of the preceding claims in a digital storage oscilloscope.

## Revendications

1. Dispositif de traitement de signaux dans une installation de saisie de signaux (10) comprenant des moyens (13, 14, 50, 51) pour saisir le maximum (40', 42) et le minimum (40", 43) du signal à l'intérieur d'un intervalle de temps (Tᵢ) comme valeurs extrêmes ainsi qu'un générateur de valeurs moyennes (15, 52) pour déterminer la valeur moyenne du signal (11) situé à l'intérieur de l'intervalle de temps (Tᵢ),
caractérisé par
un générateur de différence (23) pour former la différence entre le maximum (40', 42) du signal et le minimum (40",43) du signal, un comparateur (27) pour comparer la différence à un seuil (46) et un sélecteur (22) pour sélectionner entre la valeur moyenne et au moins l'une des valeurs extrêmes (40', 40"), ces moyens étant conçus pour que le sélecteur (22) transmette la ou les valeurs extrêmes (40', 40") lorsque le seuil (46) est dépassé et qu'il transmette la valeur moyenne lorsque le seuil (46) n'est pas dépassé.

2. Dispositif selon la revendication 1,
caractérisé par
un convertisseur analogique/numérique (12, 54) qui numérise le signal (11) à une vitesse de détection prédéterminée fournissant un nombre de valeurs (40) du signal (11) supérieur au nombre de valeurs transmises.

3. Dispositif selon la revendication 2,
caractérisé en ce que
la vitesse de détection du convertisseur analogique/numérique (12) est fixée à la valeur maximale possible du convertisseur (12).

4. Dispositif selon l'une des revendications 1 à 3,
caractérisé par
une mémoire (29) pour enregistrer des valeurs extrêmes transmises (40', 40", 42, 43) et la valeur moyenne ainsi qu'un dispositif d'affichage (30) pour reproduire les valeurs mises en mémoire (42, 43).

5. Dispositif selon des revendications 1, 2 ou 4,
caractérisé en ce que
les moyens (50, 51) pour saisir le maximum et le minium ainsi que le générateur de valeurs moyennes (52) fonctionnent de façon analogique et leurs signaux de sortie sont appliqués dans un ordre cyclique au convertisseur analogique/numérique (54) dont la vitesse de détection est fixée à une valeur correspondant au plus à un tiers de l'intervalle (Tᵢ).

6. Dispositif selon la revendication 5,
caractérisé en ce que
le générateur de valeurs moyennes (15, 52) est réalisé sous la forme d'un filtre passe-bas.

7. Dispositif selon la revendication 6,
caractérisé en ce que
la fréquence limite du filtre passe-bas est fixée en fonction de la vitesse de détection du convertisseur analogique/numérique (12, 54).

8. Dispositif selon l'une quelconque des revendications précédentes,
caractérisé en ce que
le seuil (46) est fixé en fonction du bruit systématique que l'on détermine sans signal à traiter (10).

9. Application du dispositif selon l'une quelconque des revendications précédentes à un oscilloscope à mémoire numérique.
